(19)

Europäisches Patentamt
European Patent Office
Office européen des brevets

(11) **EP 4 246 597 A1**

(12) **EUROPEAN PATENT APPLICATION**

(43) Date of publication:
**20.09.2023 Bulletin 2023/38**

(21) Application number: **22465517.5**

(22) Date of filing: **17.03.2022**

(51) International Patent Classification (IPC):
**H01L 31/0224** (2006.01)   **H01L 31/0232** (2014.01)
**H01L 31/101** (2006.01)   **H01L 31/108** (2006.01)

(52) Cooperative Patent Classification (CPC):
**H01L 31/1013; H01L 31/022408; H01L 31/02327;
H01L 31/1085**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicants:
• **SC Nanom Mems Srl**
  **505400 Rasnov, jud Brasov (RO)**
• **Cantabria University**
  **39005 Santander (ES)**
• **CNR-Nanotec**
  **70126 Bari (IT)**
• **Tyndall National Institute**
  **T12 R5CP Cork (IE)**

(72) Inventors:
• **COBIANU, Cornel**
  **051434 Bucharest (RO)**

• **GHEORGHE, Marin**
  **505400 Rasnov, Jud. Brasov (RO)**
• **GUTIERREZ, Yael Vela**
  **39007 Santander (ES)**
• **LOSURDO, Maria**
  **70126 Bari (IT)**
• **MODREANU, Mircea**
  **Cork (IE)**
• **MORENO GRACIA, Fernando**
  **39005 Santander (ES)**
• **SANTOS PERODIA, Gonzalo**
  **39011 Santander (ES)**

(74) Representative: **Fierascu, Cosmina-Catrinel**
  **Rominvent SA**
  **35 Ermil Pangratti Street**
  **Sector 1**
  **011882 Bucharest (RO)**

Remarks:
Amended claims in accordance with Rule 137(2) EPC.

(54) **MULTIBAND, MULTI-POLARIZATION PLASMONIC PHOTODETECTOR AND FABRICATION METHOD**

(57)    The present disclosure presents an innovative design concept for metal interdigitated grating-based metal-semiconductor-metal Schottky plasmonic photodetectors, able to detect multiband, multi-polarization electromagnetic radiation in the ultraviolet, visible, near and mid infrared spectrum by a using a single device with two electrodes which are both positioned on the same surface of semiconductor device, being thus a genuine planar semiconducting technology. The innovative concept shows that even if the surface plasmon enhanced photosensitive devices are wavelength and polarization-selective, it is possible to detect two and more narrow bands of the electromagnetic radiation with different polarizations by using a single-device two-electrode plasmonic Schottky photodetector where both metal contacts are placed on the device surface which is receiving the radiation. The novel design concept and associated fabrication technology will be presented by means of a generic metal-semiconductor-metal device, and specific examples will be then described.

FIG. 1

EP 4 246 597 A1

## Description

Technical field

Embodiments are related to the novel design concepts of plasmonic photodetectors for electromagnetic radiation sensing, the ultraviolet, visible, near and mid infrared spectrum. Embodiments are related to means of increasing the ability of a two-electrode, single-device interdigitated grating based Schottky plasmonic photodetector to detect more wavelength bands, and polarizations of the incident radiation with respect to grating vector.

## BACKGROUND OF THE INVENTION

There is an increasing interest in the industrial development of the visible light photodetectors considering their applications in CMOS imaging sensor, medical imaging and emerging wireless visible light communication (VLC), the so-called Li-Fi technology. Revolutionary technologies and devices are still demanded by these and future applications. On the other hand, the technology of the photodetectors for existing optical fiber telecommunication at 1.3 and 1.55 $\mu$m, traditionally based on GaAs or InP technology may further benefit from enhanced plasmonic photocurrents which may reduce their noise and increase the detectivity.

The visible range photodetectors are photovoltaic devices able to detect light with the wavelength of 370-670 nm. These photodevices, like the semiconductor p-n junction, convert the incident light into an electrical current when the energy of photons absorbed in the semiconductor is higher than the bandgap of the semiconductor. In this case, the absorbed photons generate electron-hole pairs in the semiconductor, which are separated by the electric field from the depletion region of the p-n junction, and, then they enter the external electric circuit determining the photocurrent. The minimum energy of photons which can generate electron-hole pairs in semiconductor is equal to the bandgap energy (Eg) of that semiconductor (Eg, example for silicon, Eg=1.1 eV). The absorbed photons with energy equal to bandgap energy will have the wavelength equal to 1.24/Eg, i.e., of 1.13 $\mu$m, which is called absorption edge.

Unlike the above photodetectors based on semiconducting p-n junctions characterized by electron-hole pairs generation in semiconductor due to absorbed photons with energy higher than the bandgap, there are Schottky diode photodetectors, based on the contact between a metal and a semiconductor which can generate photocurrent due to photons absorbed in the semiconductor, as described above, as well as due to photons absorbed in the metal. In this last case, the photons with energy lower than the semiconductor bandgap but higher than the Schottky barrier between metal and semiconductor, and which are absorbed in the metal near the interface (less than 40 nm) between metal and semiconductor may provide enough energy to a fraction of electrons ("hot" electrons located below or at the Fermi level of metal) and thus they may be able to surmount the Schottky barrier (0.3-0.8 eV). These hot electrons are then accelerated by the electric field from the depletion region from metal-semiconductor interface and will reach the external circuit where they determine the photocurrent. This process is called internal photoemission (IPE). Such a Schottky photodetector can extend its detection bandwidth from visible range up to a wavelength of 4 $\mu$m, in the near infrared spectrum, depending on the height of the Schottky barrier. However, the quantum efficiency of these photodetectors is much lower than in the case of photocurrent provided by electron-hole pairs generation.

Schottky diode photodetectors were extensively used for the demodulation of the optical signal from optical fiber telecommunication. The planar technology with simultaneous fabrication of both metal interdigitated electrodes on the same surface, the so-called metal-semiconductor-metal (MSM) process was extensively used for Schottky diode fabrication as it was compatible with the integrated circuit technology and was implemented by a very simple fabrication process. High fidelity of retrieved electrical signal required a strong decrease of the response time and an increased quantum efficiency of these photodetectors, which are conflicting demands, as long as short response time needs rapid transit time of electrons and small capacitance, both of them providing low quantum efficiency and associated photocurrent. The technical solution for fulfilling both short response time and higher quantum efficiency of photodetectors was the concentration of the electromagnetic near-field in the light sensing area by means of surface plasmons polaritons (SPP) defined as a dualism of light surface waves and collective electronic oscillations on the surface of metals, which are bounded at the interface between periodic nanostructured metal and a dielectric substrate (T. Ishi, J. Fujikata, K. Makita, T. Bara and K. Ohashi, Si Nano-Photodiode with Surface Plasmon Antenna, Japanese Journal of Applied Physics, Vol. 44, No. 12, 2005, pp. L 364 -L368). Thus, the photocurrent of this plasmonic photodetector may be increased by more than an order of magnitude. This approach was driven by the discovery of the extraordinary transmission of light through subwavelength hole arrays (T. W. Ebbesen, H.J. Lezec, H.F.Ghaemi, T. Thio, P.A. Wolff, Extraordinary optical transmission through arrays, Nature, vol. 391, 12 February 1998, pp. 687-689.)

As the momentum of the surface plasmons is higher than the momentum of the incident light, the generation of the surface plasmon at the upper metal-air interface or lower metal-dielectric interface in the presence of incident light is possible only by introduction of a prism, a topological defect (subwavelength hole) or a periodic corrugation of metal surface, or a metal grating. Thus, the momentum conservation law between (i) the surface plasmon ($\hbar * k_{spp}$; where $k_{spp}$

is the wave vector of the surface plasmon),(ii) incident light ($\hbar^* \mathbf{k_o}$; where $k_o = \omega/c = 2\pi/\lambda$ is magnitude wave vector of incident light in free space, and is the reduced Planck constant) and (iii) the topological defect, like a grating ($\hbar * k_\wedge$; where $k_\wedge = 2\pi/\Lambda$ is the magnitude of the wave vector, $k_\wedge$, of the grating and $\Lambda$ is the period of the grating, while the ($k_\wedge$) vector direction is perpendicular to the length of the digits) will be fulfilled if:

$$k_{spp} = k_o * \sin(\theta) + i * k_\Lambda$$

[1]

where $\theta$ is the incidence angle of the light, i is an integer and $\mathbf{k_{spp}}$ is the wave vector of the surface plasmon, which has a magnitude which is given by the relation:

$$k_{spp} = (\omega/c) * \sqrt[2]{(\varepsilon m * \varepsilon d)/(\varepsilon m + \varepsilon d)}$$

[2]

In equation [2], $\varepsilon m$ is the dielectric constant of the metal (complex number) and $\varepsilon d$ is the dielectric constant of the dielectric material in contact with the metal, both parameters being wavelength dependent, while the magnitude of the wave vector of the surface plasmons, $k_{spp}$, is a complex number if the real part of the metal dielectric constant is smaller than - $\varepsilon d$ (C. Genet and T.W. Ebessen, Light in tiny holes, Nature Reviews, vol. 445, 4 January 2007).

From equation [1] one can see that if the incidence angle $\theta = 0$ (incident light is perpendicular on the surface of the photodetector, the momentum of incident light $ko^*\sin(\theta)$ is equal to zero and the entire "work" of surface plasmon generation is done only by the grating momentum which should be equal to the surface plasmon polariton momentum.

On the other hand, for the case of incidence angle $\theta$ not being equal to zero, from equations [1] and [2] one can notice that surface plasmon generation at an interface between metal and dielectric is possible only for a certain value of the incidence angle, incident wavelength and period of grating, and this explains the wavelength and incident angle-selective property of the plasmonic photodetectors based on a grating with a certain periodicity. The period of the grating is obtained from the spatial frequency of the corrugation of a surface, or in the case of an interdigitated metal gratings this is equal to the sum of a width of a metallic finger/digit and the interspace between two adjacent metal fingers/digits. Calculation of the period of a plasmonic grating is providing a value which is smaller than the wavelength of the incident light, and therefore one can say that one obtains subwavelength grating.

The equation [1] from above is a vectorial equation, where the magnitudes of the involved vectors have been defined above. From this equation, one can see that the surface plasmon wave vector is a vectorial summation of the wave vector of light and grating.

The incident light moving towards the grating located on the surface of a photodetector is an electromagnetic wave with a wave vector $\mathbf{k_o}$, which can propagate either as **TM** mode, when the magnetic field is transversal on the incidence plane and electric field is along the incidence plane (this is called **p-polarized light),** or as a **TE** mode, when the electric field is transversal on the incidence plane and the magnetic field is located along the incidence plane **(s-polarized light).** The maximum efficiency for the surface plasmon generation, according the equation [1] is obtained when wave vector of light, $k_o$, is parallel to the grating vector $\mathbf{k_\wedge}$, i.e., when the electric field vector, $\mathbf{E_L}$, of the incident light is perpendicular to the length of the digits **(p-polarized light,** which is exciting the TM mode).

The polarization angle between the electric field (of the incident light) and the direction of the grating vector should be equal to zero for a maximum efficiency of the photocurrent, as shown in equation [3]. From this statement, one can deduce that the photocurrent of the detector is not only wavelength and incidence angle selective, but also polarization-selective! (M Jestl, I. Maran, A. Kock, W. Beinstingl and E. Gornik, Polarization sensitive surface plasmon Schottky detectors, Optics Letters, July 15, 1989, vol.14, No. 14.). In this paper it is shown that the photocurrent, $I_{ph}$, has a dependence on the polarization angle, $\delta$, between the incident light electric field vector, $E_L$, and grating vector as follows:

$$I_{ph} = I_{back} + I_{spp} * \cos^2(\delta)$$

[3]

where $I_{back}$ is the background current in the absence of the grating and $I_{spp}$ is maximum photocurrent value due surface plasmon polariton generated by metal grating, when its $\mathbf{k_\wedge}$ vector is parallel with the electric field vector, $\mathbf{E_L}$, of the incident light **(p-polarized light).** The dependence of photocurrent from the equation [3] on $\cos^2(\delta)$ comes from the fact that the photocurrent is proportional to the intensity of the light which depends on the square of the electric field magnitude.

Under these considerations, the plasmonic devices can be used as optoelectronic filters, where the responsivity of the photodetector has a very narrow bandwidth, with a full width half maximum (FWHM) band which is in the range of 50-100 nm and even lower.

The equations [1] and [2] from above are essential for the design of the subwavelength period of the gratings used for the generation of the surface plasmon and the associated near field enhancement at the interface between metal and dielectric.

In accordance with the above general theoretic description, the US Patent 8462420 B2 discloses a wavelength-selective tunable plasmonic filter consisting of a subwavelength interdigitated metallic grating used in front of a light source. Such subwavelength grating is reflecting most of the incident light and allowing the extraordinary optical transmission of the desired narrow wavelength band, which is then absorbed in a light absorption layer of a flat panel display. The design of the period of the metal plasmonic grating was done according to the basic principles described in the sections from above. The invention is also disclosing a plasmonic photodetector array, where the grating of each photodetector is designed so that only a color from the incident light to be converted into electrical signal and thus detected. What is specific to this invention is the fact that due to wavelength-selective feature of the surface plasmon generation, for each narrow wavelength band detected, a separate plasmonic filter or a photodetector device, with separate contacting pads and readout circuit is needed.

The US Patent 8759932B2 discloses photodetectors with plasmonic structures aiming at generating two-dimensional pixel arrays, where each pixel has its own plasmonic grating, with its specific subwavelength period and polarization of the incident electromagnetic radiation with respect to the grating vector. Two or more such pixels (combined in a macro-pixel) are electrically connected in parallel and are formed on a single metal-semiconductor metal (MSM) photodetector device so that to detect electromagnetic radiation of larger bandwidth and different polarizations of the electric field with respect to grating. The novelty of the invention comes from decoupling the optical function from the electrical function of the plasmonic grid. Thus, the metallic plasmonic grid placed on the top side of the device in front of incident electromagnetic radiation remains only with the optical function of surface plasmon generation, while the electrical contact to n-type region formed in the CdHgTe or CdZnTe semiconductor is performed on the back side of the photodetector.

Unfortunately, this is a complex non-planar technology, where one needs double-side alignment of the masking process on the back side of the wafer with respect to front side pattern, and also it needs drilling and making metal vias through the entire wafer for contacting the n-type region of the semiconductors.

The US Patent 8759932 B2 discloses a photodetector with plasmonic structure, consisting of a plurality of out of plane 3 D semiconducting light receiving elements and a periodic metal pattern located in the horizontal plane, in between 3D geometry. The out of plane 3D light receiving elements have different shapes, like cylinders, truncated pyramids or pyramids, while the in-plane metal pattern distributed in between and at the bottom of the 3D elements is in contact with the semiconductor and forms a periodic plasmonic structure of the photodiode tuned for the detection of certain wavelength as discussed in the background section. Similar to the effect of anisotropic etching of silicon surface which is aiming to reduce the effect of the incidence angle of the light on efficiency of the solar cells, in this case, the 3D "rough" surface of the photodetector increases the area of light receiving elements and decreases the dependency of the photodetector responsivity on the incidence angle.

## SUMMARY

The present disclosure presents an innovative design concept for metal interdigitated grating-based metal-semiconductor-metal Schottky plasmonic photodetectors, able to detect multiband, multi-polarization electromagnetic radiation in the ultraviolet, visible, near and mid infrared spectrum by a using a single device with two electrodes which are both positioned on the same surface of semiconductor device, being thus a genuine planar semiconducting technology. The innovative concept shows that even if the surface plasmon enhanced photosensitive devices are wavelength and polarization-selective, it is possible to detect two and more narrow bands of the electromagnetic radiation with different polarizations by using a single-device two-electrode plasmonic Schottky photodetector where both metal contacts are placed on the device surface which is receiving the radiation. The novel design concept will be presented by means of a generic metal-semiconductor-metal device, and specific examples will be then described.

## BRIEF DESCRIPTION OF DRAWINGS

The embodiments of the present disclosure will be described only as an example, by reference to Figs. 1- 8 of the accompanying drawings in which:

Fig. 1 shows a perspective view of a generic single band single-polarization plasmonic photodetector based on metal-semiconductor-metal (MSM) Schottky barrier, in accordance with at least one example of the present invention.

Fig. 2 shows in part (a) A top-view of the single band single-polarization of the MSM Schottky plasmonic photodetector based on interdigitated grating with dual role: electric and optic, and, in part (b) A cross-section view through the axis A-A' of the photodetector from Fig. 2(a).

Fig. 3 shows a generic photocurrent plot of a grating-based single band single-polarization photodetector MSM plasmonic Schottky photodetector from the Fig. 2 as a function of the wavelength of the incident radiation.

Fig. 4 shows in part a) A top view of schematic lay-out for a generic multiband, single-polarization grating-based plasmonic MSM Schottky photodetector, and, in part b) A cross-section view through A-A' axis of a generic multiband grating-based plasmonic MSM Schottky photodetector.

Fig. 5 shows a photocurrent plot of a generic multiband single-polarization interdigitated grating based plasmonic MSM Schottky photodetector as function of the incident light wavelength.

Fig. 6 shows a top-view of the schematic layout of a generic multiband, multi-polarization, interdigitated grating-based plasmonic MSM Schottky photodetector.

Fig. 7 shows a photocurrent plot of a generic multiband, multi-polarization, interdigitated grating-based plasmonic Schottky MSM photodetector as a function of incident light wavelength and different polarization angles between the incident light electric field vector and grating vectors.

Fig. 8 shows the technological steps and the materials used for the fabrication of a generic multiband multi-polarization interdigitated grating-based plasmonic MSM Schottky photodetector.

DETAILED DESCRIPTION

The following description should be read and understood with reference to the above drawings. These drawings are not necessarily at scale and are not intended to limit the scope of the invention. Although different examples of the design of the novel plasmonic photodetectors are illustrated in those figures, the people skilled in the art will recognize that the provided examples have many suitable alternatives that may be utilized.

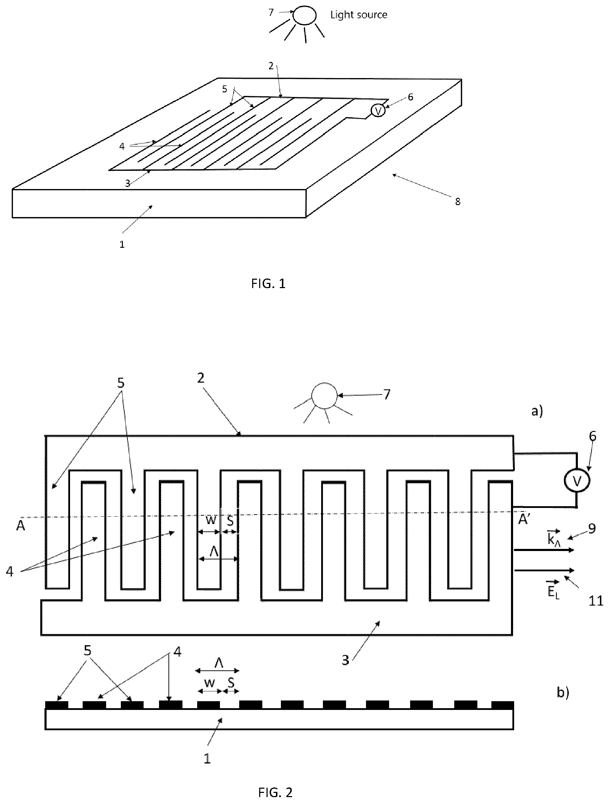

Fig. 1 shows a schematic perspective-view of an interdigitated grating-based single band single- polarization metal-semiconductor metal (MSM) plasmonic Schottky photodetector (8), which is defined as two-electrode optoelectronic device with both electrodes placed on the same surface of semiconductor substrate (1), where the planar metallization of the device, 8, in direct contact with the semiconductor 1 has dual role, i.e., both electric role as metal electrode for extracting the photocurrent from the device, and optic role, as grating, for the generation of the surface plasmon at the interface between metal and air or metal substrate when the sum of the incident light momentum and the grating momentum is equal to the surface plasmon polariton momentum, as described in the background of this invention. The first collecting electrode, 2, is provided with a number of digits, 5 positioned perpendicularly on the first collecting electrode, 2, and the second collecting electrode, 3, is provided with a number of digits, 4, positioned perpendicularly on the second collecting electrode. These fingers, 4 and 5, are interpenetrated, without touching one another, as shown in Fig. 1. These collecting electrodes, 2 and 3 are connected to a dc power supply, 6. In the same circuit a microampere meter can be added for photocurrent measurement. Together, the first, 2, and the second, 3 collecting electrodes together with their digits, 5, and 4 respectively, define also an interdigitated grating with a certain periodicity of the finger and spacing between them. The external radiation source, 7, is placed above the grating, and the incident radiation is characterized by wavelength, incidence angle with respect to normal direction on the photodetector surface and polarization angle of the electric field $E_L$, 11, with respect to the grating vector, $k_\wedge$, 9, as defined in the background. The signification of "single band single-polarization" term is that the photodetector has a single wavelength band of the incident radiation, given by grating period, which can be detected, and a single polarization angle, 6, (corresponding to $E_L \parallel k_\wedge$) of the incident radiation which provides a maximum plasmonic photocurrent, and this will be further discussed below.

Fig. 2 illustrates in (a) A detailed description of the top-view of the interdigitated grating-based plasmonic single band single-polarization MSM Schottky photodetector and in (b) A cross-section view of the same photodetector. Thus, in Fig. 2 (a), where the reference numbers have the same significance as in Fig. 1, it is easy to notice that the period of the grating is equal with the sum between the width ,W, of the fingers 4 or 5 and the space ,S, between two adjacent fingers 4 and 5. The grating with the period, A=W+S, is optically characterized as a vector, by the grating vector, $k_\wedge$, with the magnitude, $k_\wedge = 2\pi/\Lambda$, and the direction perpendicular to the length of the digits, as shown by the vector 9, in Fig. 2 (a). In Fig. 2 (a) the electric field vector, $E_L$, 11, is parallel to the grating vector, $k_\wedge$, 9 and perpendicular to the length of the digits and this means that the light is **p-polarized.** For this vectorial configuration, the polarization angle, $\delta$, between the incident light and the grating is equal to zero, and therefore according to the equation [3] the generated plasmonic photocurrent is maximum, only for this case of $E_L \parallel k_\wedge$. In Fig. 2(b), one can notice that the metal fingers, 4, and 5 make a direct contact on the surface of the semiconductor, 1.

For the realization of a plasmonic photodetector, the metals used should have real part of the dielectric constant with a negative value in the optical spectrum, which real part of the dielectric constant should be lower than the real part of negative value of the dielectric constant of the material from the interface, either air (with dielectric constant equal to 1), or the solid material from the interface with the substrate, 1,. Such metals are gold, silver, aluminum, or even gallium. The height of the Schottky barrier between metal and semiconductor depends on the work function of metal, the electron affinity in the semiconductor, the type of semiconductor (n-type or p-type), and the density of the surface states at the interface between metal and semiconductor, in the energy bandgap of the semiconductor,1. If this density of states is very high, the barrier height will be very weakly dependent or even not dependent on the metal work function.

As described in the previous sections, the grating-based single band single-polarization plasmonic MSM Schottky photodiode from Figs 1 and 2 can create surface plasmon enhanced photocurrent via electron-hole pairs generation for incident radiation with energy higher than the bandgap, while for lower incident energy than the bandgap, but higher than the Schottky barrier and specific period of the grating, the photodetector can generate photocurrent at much higher wavelengths in the near-infrared or even mid-infrared region. As an example, in the case of a metal interdigitated grating-based single band single-polarization MSM Schottky plasmonic photodiode from Figs. 1 and 2, performed with interdigitated gold metallization and n-type silicon, for the **p-polarized,** incident light with energy higher than the bandgap (1.1 eV) (wavelength lower that 1.12 $\mu$m), a surface plasmon enhanced photocurrent due to electron-hole pairs generation in the semiconductor can be tuned in the visible region for a certain period of the grating.

As an example, for the case of incident radiation with energy lower than 1.1 eV but higher than Schottky barrier of Au/Ti/Si of about 0.5 eV, and an interdigitated grating period tunned to optical constants of the used materials and incident light (see equation 1-2 from background section), an enhanced plasmonic photocurrent can be obtained for an incident near-infrared radiation with wavelength below 2.48 $\mu$m, as shown below. For a more detailed technological description, it is shown that for a good adherence of the gold on the silicon, a very thin layer of titanium or titanium nitride of 2-3 nm is deposited first on silicon and then the gold layer with thickness from 100 to 200 nm. For the case of Au/Ti metallization on n-type silicon, the Schottky barrier height was found equal to 0.5 eV (Ali Sobhani, et al, Narrow band photodetection in the near-infrared with a plasmon-induced hot electron device, Nature Communications, 2013, DOI:10.1038/ncomms 2642). In this last case, a resonant absorption of the near-infrared light in the metal (near the interface with silicon) with the absorption peak at the 1.4 $\mu$m and FWHM of 52 meV was found for a grating with Au finger width equal to 950 nm, the interdigit spacing equal to 250 nm ($\Lambda$=1.2 $\mu$m), and the Au film thickness in the range of 100-200 nm. The photocurrent spectral responsivity of the of the plasmonic single band single-polarization Schottky photodetector is much higher for the case of current provided by electron-hole pair generation in the semiconductor with respect to the that provided by plasmon-induced hot-electrons surmounting the Schottky barrier.

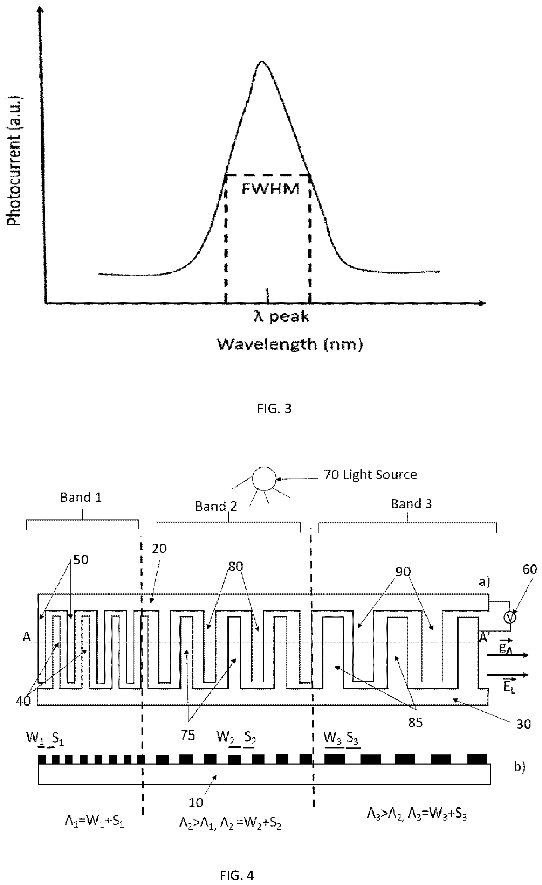

Fig. 3 illustrates the dependence of a generic surface plasmon-enhanced photocurrent as a function of the wavelength of the **p-polarized** incident radiation. As described in the background section, such a resonant peak in the photocurrent, localized at the wavelength denoted "$\lambda_{peak}$" can be determined from the theoretic equations described in equations [1-3]. This generic plot with the narrow spectral width of the photocurrent is a demonstration of the wavelength-sensitive behavior of the plasmonic single band single-polarization photodetector, acting as a narrow-band pass filter. Depending on the dispersion of optical constant of involved materials with wavelength, the type of semiconductor, the FWHM of the spectral width of the plasmonic photocurrent can vary from 100 to 200 nm, with a minimum value for the case of interdigitated grating-based plasmonic Schottky photodetectors for near-infrared radiation (100 nm), as shown in the paper of Ali Sobhani from above.

In applications like flat panel display, as described in the US Patent 8462420 B2 from prior art, there is an array of plasmonic filters in front of the photodetector, where each pixel is composed of many subpixels, and each subpixel is a plasmonic filter tunned on a certain wavelength peak as described in Fig. 3 from the present invention. In addition, each subpixel has two pads for connecting each filter to a readout circuit. This means a that each pixel consisting of many subpixels in the array of pixels is occupying a large area and an increased number of connecting pads to the readout circuit. It is the purpose of this invention to show an innovative design of such a pixel array, where *a single two-electrode photosensitive device* contains a large number of embedded narrowband-pass filters and plasmonic photodetectors, each of them being tuned to a certain wavelength peak, as shown in Fig. 3.

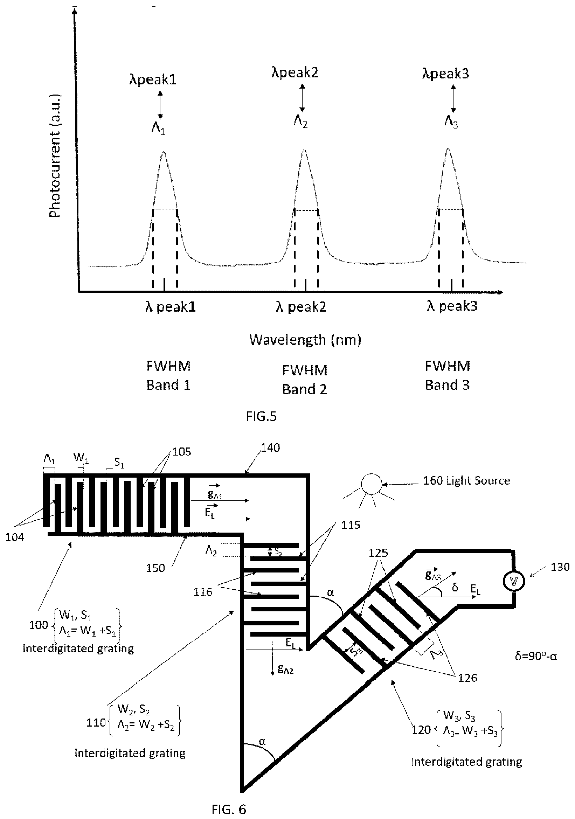

Fig. 4 (a) illustrates the concept of an innovative photodetector array by means of a schematic top-view layout of a generic, two-electrode, interdigitated grating-based plasmonic MSM Schottky *multi-band single-polarization* photodetector, which acts alone as a multi narrowband pass-filter single-polarization *and* a photodetector, and is connected to the readout circuit by only two collecting electrodes placed on the same surface, with the reference numbers 20 and 30. By analogy with the above description of pixels and subpixels, in Fig. 4 (a) the present inventors show an example of an array of three narrowband-pass filters and photodetectors embedded in a *single device* defined as two-electrode multiband single-polarization MSM grating-based plasmonic Schottky photodiode. For the case from Fig. 4(a) the polarization angle, $\delta$, between the electric field vector, $E_L$ and each of the grating vectors, $g_{\wedge1}$ $g_{\wedge2}$, $g_{\wedge3}$ has the same value ($\delta$=0), as the three different gratings in this picture have their metal digits parallel to each other and perpendicular to the two collecting electrodes. This means that there will be a single-polarization angle of the incident radiation (corresponding to $E_L \parallel g_{\wedge1}$ $g_{\wedge2}$, $g_{\wedge3}$) for which a maximum plasmonic photocurrent is obtained for each of the three photodetectors. However, each of the three plasmonic photodetectors embedded in this two-electrode device is tuned to a different wavelength band, with a different $\lambda_{peak}$ (see Fig. 5 (b)) by means of a specific periodicity of the wavelength-specific grating.

In Fig. 4 (b) a cross-section view through the axis A-A' from Fig. 4a) is illustrated. This cross-section view of the single-device multiband single-polarization photodetector demonstrates another innovative feature of the invention related to the positioning of the two metal electrodes, i.e., first collecting electrode, 20, and the second collecting electrode 30, which are placed on the same surface of the semiconductor 10, in front of the light source, 70. From this cross-section view, one can easily identify that each of the three photodetectors has its own grating periodicity, denoted by $\Lambda_1$, $\Lambda_2$, $\Lambda_3$, defined by $\Lambda_1=W_1+ S_1$, $\Lambda_2=W_2+ S_2$ and $\Lambda_3=W_3+ S_3$ values, respectively. As schematically shown in Fig. 4, the periods of the three gratings for this example are in the relation: $\Lambda_1 <\Lambda_2< \Lambda_3$. All the other relations are possible. The methodology for calculating these periods have been described in the background section.

According to Fig. 4 (a), the first photodetector has an interdigitated grating with the digits 40 connected to the second collecting electrode 30 and the digits 50 connected to first collecting electrode, a grating period equal to $\Lambda_1$ ($\Lambda_1=W_1+S_1$) and a narrowband pass filter characteristic with the spectral width named "Band 1". According to the Fig. 4 (b), the digits 40 and 50 have the width equal to W1 and the spacing between two adjacent digits equal to S1. Similarly, the second photodetector has an interdigitated grating with the digits 75 connected to the second collecting electrode 30 and the digits 80 connected to first collecting electrode 20, a grating period equal to $\Lambda_2$ ($\Lambda_2=W_2+S_2$) and a narrow band pass filter characteristic with the spectral width named "Band 2". According to the Fig. (4) b, the digits 75 and 80 have the width equal to $W_2$ and the space between two adjacent digits, equal to $S_2$. Finally, the third photodetector has an interdigitated grating with the digits 85 connected to the second collecting electrode 30 and the digits 90 connected to first collecting electrode, 20, a grating period equal to $\Lambda_3$ ($\Lambda_3=W_3+S_3$) and a narrowband pass filter characteristic with the spectral width named "Band 3". According to the Fig. 4 (b), the digits 85 and 90 have the width equal to $W_3$ and the space between two adjacent digits equal to $S_3$.

According to the theoretic background, the efficiency of the surface plasmon generation is maximum for the case of TM mode of the incident radiation, for which the electric field vector ($E_L$) is located in the incidence plan and is oriented perpendicularly on the length of the digits, 40, 50, 75, 80, 85 90 (p-polarized light). Thus, the electric field vector $E_L$ is parallel with grating vectors $g_{\wedge1}$, $g_{\wedge2}$, $g_{\wedge3}$ and the polarization angle between incident radiation and each grating is 6=0, as shown in Fig. 4 (a). Under these conditions the field enhancement in the semiconducting body (10), below the surface, from Fig. 4 (b) is maximum and the plasmonic photocurrent is maximum for a single-polarization angle ($\delta$=0), as demonstrated by means of the equation [3].

Fig. 5 shows the generic dependence of the photocurrent of the two-electrode single-device multi-band single-polarization interdigitated grating metal-semiconductor-metal Schottky photodetector from Fig. 4 as a function of the wavelength of the incident radiation, for the case of TM mode p-polarized light, with polarization angle between the electric field vector, $E_L$ and grating vectors $g_{\wedge1}$ $g_{\wedge2}$, $g_{\wedge3}$ equal to zero, i.e., and incident radiation with electric field vector perpendicular on the surface of the photodetector. This plot from Fig. 5 illustrates the fact that the multi-band single polarization photodetector from Fig. 4 may detect three wavelength bands of the spectrum with the incident radiation wavelengths in the interval $(\lambda_1;\lambda_3)$ with $\lambda_1 < \lambda_{peak1}$, $\lambda_{peak1} <\lambda_{peak2} <\lambda_{peak3}$ and $\lambda_3>\lambda_{peak3}$ and the plasmonic photocurrent has a spectral dependence according to the design of the three gratings from Fig. 4. In Fig. 5, the photocurrent peak with the spectral width "Band 1" centered on the wavelength $\lambda_{peak1}$ is provided by the portion of the device from Fig. 4 having the interdigitated grating with period $\Lambda_1$. Similarly, the photocurrent peak with the spectral width "Band 2" centered on the wavelength $\lambda_{peak2}$ is provided by the portion of the device having the interdigitated grating with period $\lambda_2$. Finally, the photocurrent peak with the spectral width "Band 3" centered on the wavelength $\lambda_{peak3}$ is provided by the portion of the device having the interdigitated grating with period $\Lambda_3$. The maximum photocurrent of each of the three photodetectors is obtained for a single polarization angle value, associated to $E_L \parallel g_{\wedge1}$, $g_{\wedge2}$, $g_{\wedge3}$, i.e.(6=0).

Taking into consideration that the photocurrent is proportional with light absorption coefficient of the semiconductor, the amplitude of the three photocurrent peaks from Fig. 5 may be somehow different, even if in Fig. 5 they are almost equal. The three photocurrent peaks from Fig. 5 may be for example the photocurrents associated to the detection of red, green, blue (RGB) colors of the visible spectrum from a two-electrode single device multi-band single polarization interdigitated grating-based MSM plasmonic Schottky photodetector performed in silicon technology (Au/Ti/Si), where $\lambda_{peak1}$ is about 400 nm (blue), $\lambda_{peak2}$ is about 525 nm (green) and $\lambda_{peak3}$ is about 625 nm (red), while the photocurrent current is obtained by electron-hole pairs generation for above bandgap incident radiation.

In the case of an interdigitated grating MSM Schottky plasmonic photodetector performed on GaN semiconductor, (bandgap equal to 3.4 eV) for photon energy higher than 3.4 eV, ($\lambda$<360 nm), enhanced generation of electron-hole pairs may be used for multiband detection single polarization of a plasmonic photocurrent in the ultraviolet spectral range, for specific subwavelength periods of the interdigitated grating, calculated according to equations (1) and (2).

In another embodiment, the three photocurrent peaks from Fig. 5 could be located in the near-infrared spectrum, for the case of a two-electrode single-device multiband single polarization interdigitated grating-based MSM Schottky photodetector when the incident radiation has photon energy below the semiconductor bandgap but higher than the Schottky barrier, as discussed previously. As an example, an interdigitated grating plasmonic MSM Schottky photodetector with gold metallization on InP for multiband detection single polarization of incident radiation in the spectral range around 1.15 $\mu$m considering the specific periods of the interdigitated gratings, as discussed above.

Fig. 6 illustrates the top view schematic layout of a generic two-electrode single-device, multiband, multi-polarization, interdigitated grating-based plasmonic MSM Schottky photodetector. In this figure, as an example, three interdigitated gratings 100, 110 and 120 with their digits (104, 105), (115, 116) and (125, 126), respectively, positioned perpendicularly to the two collecting electrodes 140 and 150 which have different orientations on the surface of the device are shown. The three interdigitated gratings are all connected electrically in parallel, between the meandering first collecting electrode 140 and the meandering second collecting electrode 150, and finally, all connected to the same dc power source 130. The incident radiation has the electric field vector, $E_L$, which makes different generic polarization angles, $\delta_1$, $\delta_2$, $\delta_3$ with the three grating vectors $k_{\wedge 1}$, $k_{\wedge 2}$, $k_{\wedge 3}$, as shown in Fig. 6.

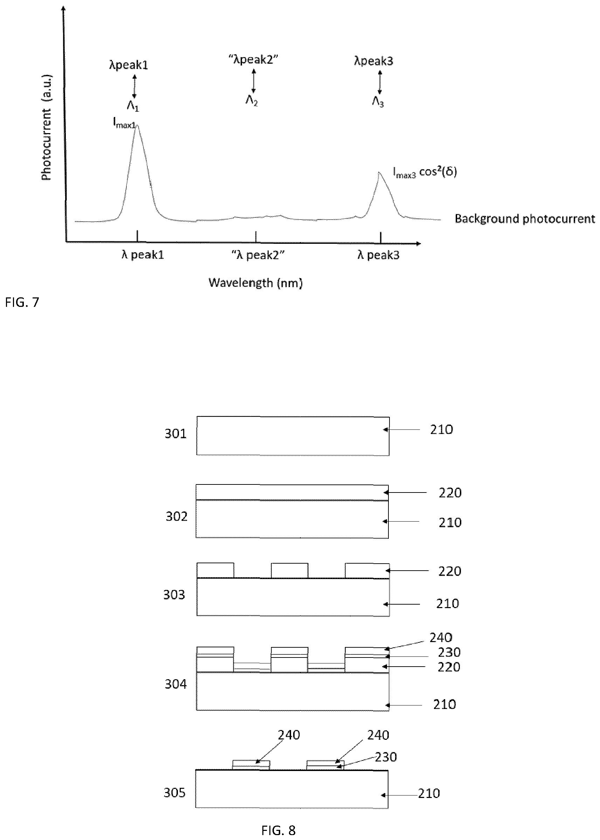

The interdigitated grating 100, has a period $\Lambda_1$ defined by the sum of the width of the digits (104, 105) equal to $W_1$ and space between two adjacent digits equal to $S_1$, and the grating vector, $g_{\wedge 1}$, parallel with the electric field vector $E_L$ of the incident light. The polarization angle between the electric field vector, $E_L$, of the incident radiation and the vector, $g_{\wedge 1}$, of the interdigitated grating 100 is therefore equal to zero. The interdigitated grating 110, has a period $\Lambda_2$ defined by the sum of the width of the digits (115,116) equal to $W_2$ and space between two adjacent digits equal to $S_2$, and the grating vector, $g_{\wedge 2}$, perpendicular on the electric field vector $E_L$ of the incident light. Therefore, the polarization angle between the electric field, $E_L$, of incident radiation and the vector, $g_{\wedge 2}$, of the interdigitated grating 200 is equal to 90°. The interdigitated grating 130, has a period $\Lambda_3$ defined by the sum of the width of the digits (125,126) equal to $W_3$ and space between two adjacent digits equal to $S_3$, and the grating vector, $g_{\wedge 3}$, makes an angle $\delta$ with the electric field vector, $E_L$, of the incident light. Therefore, the polarization angle between the electric field $E_L$ of the incident radiation and the vector $g_{\wedge 3}$ of the interdigitated grating 200 is equal to 6. By simple geometric calculations one can prove that the angle $\delta = 90°-\alpha$, where $\alpha$ is the "V" angle between two segments of a collecting electrode 140 or 160, as shown in Fig. 6. The geometry of the three interdigitated gratings and the polarization angle for each of the three photodetectors connected in parallel and embedded in the same two-electrode photosensitive device, correlated with the theoretic background from previous section, will enable an easy understanding of the spectral response of the plasmonic multiband multi-polarization device, from Fig. 7.

Fig. 7 illustrates the dependence of the plasmonic photocurrent of the two-electrode single-device multiband multi-polarization interdigitated grating-based metal-semiconductor-metal Schottky photodetector. In this figure, the interdigitated grating 100 with the period $\Lambda_1$ will determine a plasmonic photocurrent peak with a narrowband around the wavelength $\lambda_{peak1}$. As the polarization angle between the electric field vector, $E_L$, of the incident radiation and the grating vector, $g_{\wedge 1}$, of the interdigitated grating 100 is equal to zero (see Fig. 6), according to equation (3) a maximum efficiency of the surface plasmon generation and corresponding photocurrent is obtained and this is presented in the Fig. 7. The photocurrent peak with a maximum value, $I_{max1}$ is obtained at the wavelength $\lambda_{peak1}$, where $\lambda_{peak1}$ is determined by the grating period $\Lambda_1$ of the interdigitated grating (100). On the other hand, in the case of the interdigitated grating (110) of period $\Lambda_2$, as the polarization angle between the electric field of incident light ($E_L$) and the grating vector $g_{\wedge 2}$ is 90°, the plasmonic photocurrent around the wavelength $\lambda_{peak2}$ is equal to zero, as predicted by equation (3) from background section. Thus, in Fig. 7, there is no photocurrent peak at the wavelength equal to $\lambda_{peak2}$. Finally, in the case of the interdigitated grating (120), with the period $\Lambda_3$, and the polarization angle between the electric field vector of the incident light, $E_L$ and the grating vector $g_{\wedge 3}$ equal to $\delta$, ($\delta = 90°-\alpha$) the plasmonic photocurrent peak has the value equal to $I_{max3}$ $\cos^2(\delta)$, and this is shown in Fig. 7, for the case of plasmonic current at the wavelength $\lambda_{peak3}$, which value was determined from the period $\Lambda_3$. As mentioned before, the peak values of the plasmonic photocurrents, $I_{max1}$ and $I_{max3}$ are not equal, as the absorption coefficient in any semiconductor is a function of wavelength.

In other embodiments, the polarization angle between the electric field $E_L$ of incident radiation and grating vectors $g_{\wedge 1}$, $g_{\wedge 2}$, $g_{\wedge 3}$ of the three interdigitated structures, 110, 120 and 130 from Fig. 6 may be equal to $\delta_1$, $\delta_2$, $\delta_3$, and the values of these angles may be in the interval (0-90°). Considering the fact that the grating vectors $g_{\wedge 1}$ and $g_{\wedge 2}$ are perpendicular one to another (see Fig. 6), one can easily demonstrate that $\delta_2 = 90°- \delta_1$. Knowing the three photocurrent peaks from experimental measurements, and the above relation between $\delta_1$ and $\delta_2$, one can calculate the values of the three polarization angles based on the relation [3]. Thus, this example from Figs. 6 and 7 proves that by means of the design concept disclosed in this invention, one can sense multiple wavelength bands of the incident radiation in the ultraviolet, visible or near-infrared or mid-infrared range, as well as the polarization angle of the incident light with grating vectors.

A major differentiation of this invention with respect to prior art inventions described at the background section, comes also from the positioning of the two collecting electrodes on the same surface of the plasmonic photodetector, in front of the radiation source. Basically, the novelty of this invention comes also from the dual role of the metal interdigitated grating aiming both surface plasmon generation and realization of Schottky contacts between metal and semiconductor on the same surface of the photodetector.

In other embodiments materials other than silicon semiconductors are used for the realization of the two-electrode single-device multiband multi-polarization interdigitated grating-based Schottky plasmonic photodetectors, like, Germanium (Ge), AIII-BV semiconductors (GaAs, GaN, InP, InAs, GaInNAs, GaInAsP), AII-BVI semiconductors (CdHgTe, CdZnTe), AIV-BV-CVI ($Ge_2Sb_2Te_5$) semiconductors, AV-BVI semiconductors ($Sb_2S_3$, $Sb_2Se_xS_{3-x}$). For each of these semiconductors, one can develop two-electrode single-device multiband multi-polarization interdigitated grating-based metal-semiconductor-metal Schottky plasmonic photodetectors following the simple methodology described for Au/Ti/Si, where also other than Ti barriers may be used between metal like Al, Ag, Au, Ga and the selected semiconductor. Among the materials used as chemical barriers between the metal and the semiconductor, one may use an ultrathin layer (2-3 nm) of TiN, $Si_3N_4$, $SiO_2$. Such novel plasmonic Schottky photodetector can be designed to detect multiband multi-polarization incident radiation either by electron-hole generation inside the semiconductor for photon energy higher than the bandgap and/or by hot electron generation in the metal near the interface between metal and semiconductor, when the photon energy is lower than the bandgap of the semiconductor but higher than Schottky barrier between metal and semiconductor.

A generic technology for the fabrication of the multiband multi-polarization interdigitated grating-based metal semiconductor-metal plasmonic Schottky photodiode is presented in Fig. 8, which an illustrative schematic cross-sectional view of an illustrative fabrication process, which may consist of the following steps:

301: selection of semiconductor wafer, 210, according to the application requirements and spectral range of the electromagnetic radiation to be detected,

302: chemical cleaning and drying of semiconductor substrate wafer, 210, for removing the inorganic and organic particles,

303: spinning of a thick photoresist layer, 220,

304: patterning of the photoresist layer, 220, on the semiconductor wafer substrate,210

305: deposition of the chemical barrier layer, 230, of a maximum 2-3 nm thickness,

306: deposition of the metal layer, 240, of thickness in the range 200-400 nm,

307: lift-off of the of the photoresist 220, and unnecessary chemical barrier layer 230 and metal layer 240 deposited on photoresist layer, 220, for preserving only metal layer, 240, on chemical barrier layer, 230, directly deposited on the surface of semiconductor substrate wafer 210, which will form the first collecting electrode, the second collecting electrode and the interdigitated grating.

Deposition of the plasmonic metals like Au, Ag, Al and chemical barrier layers like Ti and TiN is performed by physical vapor deposition methods, like sputtering or reactive sputtering. Deposition of chemical barrier layers of $Si_3N_4$ and $SiO_2$ layers may be performed by plasma enhanced chemical vapor deposition. Preparation of the solid-state gallium layer may be performed by physically vapor deposition in vacuum, while keeping the substrate wafer cooled at the liquid nitrogen temperature.

In another embodiments, the digits of the interdigitated gratings can make an angle with the first collecting electrode and second collecting electrode, which is lower or higher than the value equal to 90°, as illustrated in Figs. 1,2, 4, 5.

In another embodiments, the grating vectors of the interdigitated structures are not perpendicular one to the others, and the number of gratings can be higher than 3, as shown in Fig. 6.

For those skilled in the art, it is easy to further design other layouts of the two-electrode multiband multi-polarization interdigitated grating-based metal-semiconductor-metal Schottky plasmonic photodetectors able to detect more than three wavelength bands, at any polarization angles between the electric field of incident radiation and the grating vectors of those interdigitated gratings, and remain within the scope of the claim attached hereto. Therefore, it will be understood that this disclosure is, in many respects, only illustrative. Changes may be made at detail level, in arrangement of the gratings, number of gratings, shape of collecting electrodes, layout size and digits orientation with respect to collecting electrodes without exceeding the scope of the invention.

## Claims

1. A single-device two-electrode multiband multi-polarization metal-semiconductor-metal Schottky plasmonic photodetector comprising:

   a first collecting electrode containing a multitude of metal digits deposited directly on a semiconductor surface,
   a second collecting electrode containing of multitude of metal digits deposited directly on the same semiconductor surface, and which are interdigitated with the metal digits of the first collecting electrode,
   a multitude of interdigitated gratings containing the interdigitated metal fingers of the first collecting electrode and of the second collecting electrode, each grating having its interdigitated digits parallel one to the other and being spatial distributed with a specific periodicity,
   a semiconductor in mechanical and electrical contact with the above first and the second collecting electrode.

2. The multiband multi-polarization photodetector from claim, 1, where the parallel digits of each interdigitated grating are making an angle equal to 90° with the first collecting electrode and second collecting electrode.

3. The multiband multi-polarization photodetector from claim, 1, where the parallel digits of each interdigitated grating are making an angle lower than 90° with the first collecting electrode and second collecting electrode.

4. The multiband multi-polarization photodetector from claim 1, where *each interdigitated grating* from that multitude of gratings acts simultaneously as (i) an optical element for coupling the incident radiation of a certain wavelength to the surface plasmon polaritons generated at metal surface for enhancing the electric field inside the semiconductor and the photocurrent, and as (ii) the two electrical contacts of a metal-semiconductor-metal plasmonic photodetector.

5. The multiband multi-polarization photodetector from claim 4, which is comprising a multitude of plasmonic photodetectors connected electrically in parallel to the first collecting electrode and second collecting electrode, each plasmonic photodetector from this multitude having its own interdigitated grating with its specific periodicity and its detection band.

6. The multiband multi-polarization photodetector from claim 5, where each plasmonic photodetector from that multitude has its own polarization angle between the electric field vector of the incident radiation and the grating vector, which angle is determining the amplitude of the photocurrent peak.

7. The multiband multi-polarization photodetector from claim 6, where the polarization angle between the electric field of the incident radiation and wave vector of each grating can be calculated from the value of photocurrent peak of each wavelength band, and the geometrical relations between different gratings and the layout of the first collecting electrode and second collecting electrode.

8. The multiband multi-polarization photodetector from claim 1, where the metals used for the fabrication of the metal-semiconductor-metal Schottky plasmonic photodetectors are gold, silver, aluminum, gallium.

9. The multiband multi-polarization photodetector from claim 1, where the semiconductor used are silicon (Si), germanium (Ge), AIII-BV semiconductors (GaAs, GaN, InP, InAs, GaInNAs, GaInAsP), AII-BVI semiconductors (CdHgTe, CdZnTe), AIV-BV-CVI ($Ge_2Sb_2Te_5$) semiconductors, AV-BVI semiconductors ($Sb_2S_3$, $Sb_2Se_xS_{3-x}$).

10. The multiband multi-polarization photodetector from claim 1, where the chemical barrier between the metal and semiconductor is an ultrathin thin film, of a 2-3 nm thickness, selected from the group of materials like Ti, TiN, $Si_3N_4$, $SiO_2$.

11. The multiband multi-polarization photodetector from claim 1, where the incident electromagnetic radiation to be detected is in the ultraviolet, visible, near and mid infrared spectral range.

12. Method for the fabrication of the multiband multi-polarization interdigitated grating metal semiconductor-metal Schottky plasmonic photodetector, consisting in: selection of semiconductor wafer according to the application requirements and spectral range of the electromagnetic radiation to be detected, chemical cleaning and drying of the semiconductor wafer for removing the inorganic and organic particles, spinning of a thick photoresist layer on the wafer, patterning of the photoresist layer on the wafer, deposition of the chemical barrier layer of a maximum 2-3 nm thickness, deposition of the metal layer of thickness in the range 200-400 nm, lift-off of the of the photoresist and unnecessary metal for preserving only metal on chemical barrier layer directly deposited on the wafer surface, which will form the first collecting electrode and the second collecting electrode and interdigitated grating.

13. Fabrication method from claim 12, where plasmonic metals like Au, Ag, Al and chemical barrier layers like Ti and TiN are prepared by physical vapor deposition methods, like sputtering or reactive sputtering.

14. Fabrication method from claim 12, where $Si_3N_4$ and $SiO_2$ layers are deposited by plasma enhanced chemical vapor deposition.

15. Fabrication method from claim 12, where gallium layer is physically vapor deposited by keeping the substrate wafer at liquid nitrogen temperature.

**Amended claims in accordance with Rule 137(2) EPC.**

1. A single-device two-electrode multiband multi-polarization metal-semiconductor-metal interdigitated grating-based plasmonic Schottky photodetector (101) comprising:

a non-collinear multi-segment first metal collecting electrode (150) and a first multitude of metal digits, (104, 116, 126) which are mechanically and electrically connected to the first collecting electrode, (150), and which first electrode, 150, and first multitude of digits, (104, 116, 126) are both deposited directly on the same semiconductor surface,
a non-collinear multi-segment second metal collecting electrode, (140), and a second multitude of metal digits (105, 115, 125) which are mechanically and electrically connected to the second collecting electrode, (140), and which second electrode (140) and the second multitude of digits (105, 115, 125) are both deposited directly on the same semiconductor surface, and which metal digits of the second multitude of digits (105, 115, 125) are interdigitated with the metal digits of the first multitude of digits, (104, 116, 126);
a multitude of interdigitated gratings, (100, 110, 120), each containing a fraction of the interdigitated metal digits of the first multitude (104,116,126), which are interdigitated with a fraction of the second multitude of digits, (105, 115, 125), each grating having its interdigitated digits parallel one to the other and being spatially distributed with a specific periodicity;
a semiconductor in mechanical and electrical contact with the above first (150) and the second collecting electrode (140) and the multitude of interdigitated gratings (100, 110, 120).

2. The multiband multi-polarization photodetector (101) from claim, 1, where the parallel digits of each interdigitated grating (100), (110), (120), are making an angle equal to 90° with the first collecting electrode (150) and second collecting electrode (140).

3. The multiband multi-polarization photodetector (101) from claim, 1, where the parallel digits of each interdigitated grating (100, 110, 120), are making an angle different than 90° with the first collecting electrode (150) and second collecting electrode (140).

4. The multiband multi-polarization photodetector (101) from claim 1, where each interdigitated grating from that multitude of gratings, (100, 110, 120), acts simultaneously as (i) an optical element for coupling the incident radiation of a certain wavelength and polarization to the surface plasmon polaritons generated at a metal surface for enhancing the electric field inside the semiconductor and the photocurrent, and as (ii the two electrical contacts of a metal-semiconductor-metal plasmonic photodetector.

5. The multiband multi-polarization photodetector (101) from claim 4, in each of the grating from the multitude of interdigitated gratings is connected electrically in parallel to the first collecting electrode (150) and second-collecting electrode (140), each grating having its own specific periodicity and its detection band.

6. The multiband multi-polarization photodetector (101) from claim 5, where each of the grating from the multitude of interdigitated gratings is **characterized by** its own polarization angle between the electric field vector of the incident radiation and the grating vector, which angle is determining the amplitude of the photocurrent peak.

7. The multiband multi-polarization photodetector (101) from claim 6, where the polarization angle between the electric field of the incident radiation and wave vector of each grating, can be calculated from the value of the photocurrent peak of each wavelength band, and/or from the geometrical relations between different gratings and the layout of the first collecting electrode (150) and second collecting electrode (140).

8. The multiband multi-polarization photodetector (101) from claim 1, where the metals used for the fabrication of the metal-semiconductor-metal Schottky plasmonic photodetector are selected from gold, silver, aluminum, gallium.

9. The multiband multi-polarization photodetector (101) from claim 1, where the semiconductors used are selected from silicon (Si), germanium (Ge), AIII-BV semiconductors (GaAs, GaN, InP, InAs, GaInNAs, GaInAsP), AII-BVI semiconductors (CdHgTe, CdZnTe), AIV-BV-CVI ($Ge_2Sb_2Te_5$) semiconductors, AV-BVI semiconductors ($Sb_2S_3$, $Sb_2Se_xS_{3-x}$).

10. The multiband multi-polarization photodetector (101) from claim 1, where the chemical barrier between the metal and semiconductor is an ultrathin thin film, of a 2-3 nm thickness, selected from the group of materials like Ti, TiN, $Si_3N_4$, $SiO_2$.

11. The multiband multi-polarization photodetector (101) from claim 1, where the incident electromagnetic radiation to be detected is in the ultraviolet, visible, near and mid infrared spectral range.

12. Method for the fabrication of the multiband multi-polarization interdigitated grating metal semiconductor-metal Schottky plasmonic photodetector, (101), according to claims 1-11, comprising the steps of: selection of semiconductor wafer according to the application requirements and spectral range of the electromagnetic radiation to be detected, chemical cleaning and drying of the semiconductor wafer for removing the inorganic and organic particles, spinning of a thick photoresist layer on the wafer, patterning of the photoresist layer on the wafer, deposition of the chemical barrier layer of a maximum 2-3 nm thickness, followed by deposition of the metal layer of thickness in the range of 10-400 nm, lift-off of the of the photoresist and unnecessary metal for preserving only plasmonic metal on chemical barrier layer directly deposited on the wafer surface, which will form the first collecting electrode (150) and the second collecting electrode, (140) and interdigitated gratings connected to them.

13. Fabrication method from claim 12, where plasmonic metals like Au, Ag, Al and chemical barrier layers like Ti and TiN are prepared by physical vapor deposition methods, like sputtering or reactive sputtering.

14. Fabrication method from claim 12, where $Si_3N_4$ and $SiO_2$ layers are deposited by plasma enhanced chemical vapor deposition.

15. Fabrication method from claim 12, where gallium layer is physically vapor deposited by keeping the substrate wafer at liquid nitrogen temperature.

FIG. 1

FIG. 2

FIG. 3

FIG. 4

FIG.5

FIG. 6

FIG. 7

FIG. 8

Europäisches
Patentamt

European
Patent Office

Office européen
des brevets

# EUROPEAN SEARCH REPORT

Application Number

EP 22 46 5517

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | CN 111 290 078 A (UNIV SOUTHEAST) 16 June 2020 (2020-06-16) * the whole document * | 1-15 | INV. H01L31/0224 H01L31/0232 H01L31/101 H01L31/108 |
| A | ZENG CHUN-HONG ET AL: "Silicon carbide and graphene based UV-IR dual-color detector", OPTOELECTRONICS LETTERS, SPRINGER, GERMANY, vol. 15, no. 3, 3 June 2019 (2019-06-03), pages 170-173, XP036797276, ISSN: 1673-1905, DOI: 10.1007/S11801-019-8154-X [retrieved on 2019-06-03] * the whole document * | 1-15 | |
| A | DARWEESH AHMAD A ET AL: "Current Density Contribution to Plasmonic Enhancement Effects in Metal-Semiconductor-Metal Photodetectors", JOURNAL OF LIGHTWAVE TECHNOLOGY, IEEE, USA, vol. 36, no. 12, 15 June 2018 (2018-06-15), pages 2430-2434, XP011682214, ISSN: 0733-8724, DOI: 10.1109/JLT.2018.2811749 [retrieved on 2018-03-29] * the whole document * | 1-15 | TECHNICAL FIELDS SEARCHED (IPC) H01L |

The present search report has been drawn up for all claims

| Place of search | Date of completion of the search | Examiner |
|---|---|---|
| Berlin | 4 August 2022 | Voignier, Vincent |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

........................................................................
& : member of the same patent family, corresponding document

EPO FORM 1503 03.82 (P04C01)

## EP 4 246 597 A1

### ANNEX TO THE EUROPEAN SEARCH REPORT
### ON EUROPEAN PATENT APPLICATION NO.

EP 22 46 5517

This annex lists the patent family members relating to the patent documents cited in the above-mentioned European search report.
The members are as contained in the European Patent Office EDP file on
The European Patent Office is in no way liable for these particulars which are merely given for the purpose of information.

04-08-2022

| Patent document cited in search report | | Publication date | Patent family member(s) | Publication date |
|---|---|---|---|---|
| CN 111290078 | A | 16-06-2020 | NONE | |

EPO FORM P0459

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 8462420 B2

- US 8759932 B2

### Non-patent literature cited in the description

- **T. ISHI ; J. FUJIKATA ; K. MAKITA ; T. BARA ; K. OHASHI.** Si Nano-Photodiode with Surface Plasmon Antenna. *Japanese Journal of Applied Physics,* 2005, vol. 44 (12), L 364-L368
- **T. W. EBBESEN ; H.J. LEZEC ; H.F.GHAEMI ; T. THIO ; P.A. WOLFF.** Extraordinary optical transmission through arrays. *Nature,* 12 February 1998, vol. 391, 687-689

- **C. GENET ; T.W. EBESSEN.** Light in tiny holes. *Nature Reviews,* 04 January 2007, vol. 445
- **M JESTL ; I. MARAN ; A. KOCK ; W. BEINSTINGL ; E. GORNIK.** Polarization sensitive surface plasmon Schottky detectors. *Optics Letters,* 15 July 1989, vol. 14 (14
- **ALI SOBHANI et al.** Narrow band photodetection in the near-infrared with a plasmon-induced hot electron device. *Nature Communications,* 2013